# EUROPEAN PATENT APPLICATION

(11) **EP 2 202 805 A1**
(43) Date of publication of application: **30.06.2010**
(21) Application number: 08864090.9
(22) Date of filing: 05.12.2008
(51) Int. Cl.: H01L 31/04

(54) **PHOTOELECTRIC CONVERTING DEVICE AND PROCESS FOR PRODUCING THE PHOTOELECTRIC CONVERTING DEVICE**

(30) Priority: 26.12.2007 JP 2007333912
(71) Applicant: Mitsubishi Heavy Industries, Ltd., Tokyo 108-8215 (JP)
(72) Inventor: TSURUGA, Shigenori, Yokohama-shi Kanagawa 236-8515 (JP); YAMAGUCHI, Kengo, Nagasaki-shi Nagasaki 851-0392 (JP); GOYA, Saneyuki, Yokohama-shi Kanagawa 236-8515 (JP); SAKAI, Satoshi, Yokohama-shi Kanagawa 236-8515 (JP)
(74) Representative: Henkel, Feiler & Hänzel
(86) International application number: PCT/JP2008/072132
(87) International publication number: WO 2009/081713

(57) **Abstract**

A photovoltaic device having improved conversion efficiency as a result of an increase in the open-circuit voltage is provided. The photovoltaic device (100) comprises a photovoltaic layer (3) having a stacked p-layer (41), i-layer (42) and n-layer (43), wherein the p-layer (41) is a nitrogen-containing layer comprising nitrogen atoms at an atomic concentration of not less than 1% and not more than 25%, and the crystallization ratio of the p-layer is not less than 0 but less than 3. Alternatively, the n-layer (43) may be a nitrogen-containing layer comprising nitrogen atoms at an atomic concentration of not less than 1% and not more than 20%, wherein the crystallization ratio of the n-layer is not less than 0 but less than 3. Alternatively, an interface layer may be formed at the interface between the p-layer (41) and the i-layer (42), wherein the interface layer is a nitrogen-containing layer comprising nitrogen atoms at an atomic concentration of not less than 1% and not more than 30%. Alternatively, an interface layer may be formed at the interface between the n-layer (43) and the i-layer (42),
wherein the interface layer is a nitrogen-containing layer comprising nitrogen atoms at an atomic concentration of not less than 1% and not more than 20%.

## Description

### Technical Field

The present invention relates to a photovoltaic device, and relates particularly to a photovoltaic device in which the electric power generation layer is formed by deposition.

### Background Art

One known example of a photovoltaic device used in a solar cell that converts the energy from sunlight into electrical energy is a thin-film silicon-based photovoltaic device comprising a photovoltaic layer formed by using a plasma enhanced CVD method or the like to deposit thin films of a p-type silicon-based semiconductor (p-layer), an i-type silicon-based semiconductor (i-layer) and an n-type silicon-based semiconductor (n-layer).

Advantages of thin-film silicon-based solar cells include the comparative ease with which the surface area can be increased, and the fact that the film thickness is approximately 1/100th that of a crystalline solar cell, meaning minimal material is required. As a result, thin-film silicon-based solar cells can be produced at lower cost than crystalline solar cells. However, a drawback of thin-film silicon-based solar cells is the fact that the conversion efficiency is lower than that of crystalline solar cells. In this technical field, improving the conversion efficiency is a very important task.

For example, in patent citation 1 and patent citation 2, the band gaps of the p-layer and the n-layer are widened by adding nitrogen to the p-layer and n-layer, thereby improving the conversion efficiency by increasing the open-circuit voltage.
Patent Citation 1: Japanese Unexamined Patent Application, Publication No. 2005-277021
Patent Citation 2: Japanese Unexamined Patent Application, Publication No. 2006-120930

### Disclosure of Invention

As disclosed in patent citation 1 and patent citation 2, as the concentration of impurities such as nitrogen is lowered, the p-layer and the n-layer tend to crystallize more readily. When the crystallization ratios of the p-layer and the n-layer are low, the conductivity decreases, and moreover if these layers are deposited on top of an i-layer, the bonding to the i-layer also deteriorates, resulting in a deterioration in the photovoltaic conversion efficiency. Accordingly, conventionally it has been accepted that the crystallization ratios of the p-layer and the n-layer must be set to high values.

Furthermore, it is known that when an impurity is added to the p-layer and the n-layer, a decrease in the carrier concentration and an increase in the defect density results in a decrease in the conductivity. In those cases where nitrogen gas is used as the raw material for adding nitrogen as an impurity, because the nitrogen gas is difficult to decompose within a plasma, incorporating a large quantity of nitrogen within the film is difficult. Consequently, in patent citation 1 and patent citation 2, nitrogen was added to the p-layer and n-layer in low concentrations from 0.001 atomic% to 10 atomic%.

In order to raise the crystallization ratio of the p-layer and the n-layer, the hydrogen dilution ratio (H₂/SiH₄) must be increased, but this raises a problem, because as the quantity of SiH₄ that functions as the raw material for the silicon layer decreases, the deposition rate of the p-layer and n-layer also decreases. In a mass production process, a decrease in the deposition rate of the p-layer and n-layer is undesirable as it results in a significant decrease in productivity. How to best improve the conversion efficiency of a solar cell while ensuring rapid deposition of the p-layer and n-layer and thus a high degree of productivity has been an ongoing problem.

The present invention has been developed in light of the above circumstances, and has an object of providing a photovoltaic device having improved electric power generation efficiency as a result of an increase in the open-circuit voltage, and a process for producing a photovoltaic device having a high open-circuit voltage by depositing a photovoltaic layer at a rapid rate.

As a result of intensive investigation, the inventors of the present invention discovered that by depositing a p-layer or n-layer comprising a high concentration of nitrogen, although the crystallization ratio of the p-layer or n-layer decreases, the band gap widens, resulting in an increase in the open-circuit voltage. As a result, the inventors were able to produce a photovoltaic device having a high conversion efficiency. Furthermore, the inventors also discovered that a photovoltaic device having high conversion efficiency as a result of increased open-circuit voltage could be obtained by inserting a layer comprising a high concentration of nitrogen at either the p/i interface or the n/i interface. Because this type of p-layer, n-layer or interface layer does not require a high hydrogen dilution ratio in order to achieve a high crystallization ratio, the layer can be formed at a high deposition rate. As a result, a photovoltaic device having high conversion efficiency due to high open-circuit voltage can be produced at a high degree of productivity.

Specifically, a photovoltaic device of the present invention comprises a photovoltaic layer having a stacked p-layer, i-layer and n-layer, wherein the p-layer is a nitrogen-containing layer comprising nitrogen atoms at an atomic concentration of not less than 1% and not more than 25%, and the crystallization ratio of the p-layer is not less than 0 but less than 3.

Furthermore, a photovoltaic device of another aspect of the present invention comprises a photovoltaic layer having a stacked p-layer, i-layer and n-layer, wherein the n-layer is a nitrogen-containing layer comprising nitrogen atoms at an atomic concentration of not less than 1% and not more than 20%, and the crystallization ratio of the n-layer is not less than 0 but less than 3.

By forming the p-layer or n-layer as a nitrogen-containing layer that comprises nitrogen atoms at an atomic concentration described above and has a crystallization ratio of not less than 0 but less than 3, the band gap is widened, thus the open-circuit voltage is increased. As a result, a photovoltaic device having a high conversion efficiency is obtained.

Furthermore, a photovoltaic device of another aspect of the present invention comprises a photovoltaic layer having a stacked p-layer, i-layer and n-layer, wherein an interface layer is formed at the interface between the p-layer and the i-layer, and the interface layer is a nitrogen-containing layer comprising nitrogen atoms at an atomic concentration of not less than 1% and not more than 30%.

If a nitrogen-containing interface layer that comprises nitrogen atoms at an atomic concentration described above is formed in this manner at the interface between the p-layer and the i-layer, then the interface layer causes a widening of the band gap, thus increasing the open-circuit voltage. Accordingly, a photovoltaic device having a high conversion efficiency can be obtained.

Furthermore, a photovoltaic device of another aspect of the present invention comprises a photovoltaic layer having a stacked p-layer, i-layer and n-layer, wherein an interface layer is formed at the interface between the n-layer and the i-layer, and the interface layer is a nitrogen-containing layer comprising nitrogen atoms at an atomic concentration of not less than 1% and not more than 20%.

If a nitrogen-containing interface layer that comprises nitrogen atoms at an atomic concentration described above is formed in this manner at the interface between the n-layer and the i-layer, then the interface layer causes a widening of the band gap, thus increasing the open-circuit voltage. Accordingly, a photovoltaic device having a high conversion efficiency can be obtained.

In the invention described above, the interface layer is preferably an intrinsic semiconductor that comprises nitrogen.
If an n-type semiconductor layer or p-type semiconductor layer that comprises nitrogen is used as the interface layer, then because the layer does not function as an electric power generation layer, the efficiency deteriorates. As a result, the i-layer must be increased in thickness by a quantity equal to the thickness of the interface layer. The present invention offers the advantage that, because an intrinsic semiconductor that comprises nitrogen is used as the interface layer, the interface layer is able to contribute to electric power generation.

In the present invention, the thickness of the interface layer is preferably not less than 2 nm and not more than 10 nm. At a thickness of less than 2 nm, the effect of the interface layer in widening the band gap is not obtained, meaning the open-circuit voltage cannot be increased. If the thickness exceeds 10 nm, then the photovoltaic conversion performance tends to deteriorate.

In the present invention, the i-layer is preferably a crystalline silicon layer.

The present invention also provides a process for producing a photovoltaic device that comprises forming a photovoltaic layer by stacking a p-layer, an i-layer and an n-layer on top of a substrate, wherein a nitrogen-containing layer comprising nitrogen atoms at an atomic concentration of not less than 1% and not more than 25% and having a crystallization ratio of not less than 0 but less than 3 is formed as the p-layer.

Furthermore, the invention also provides a process for producing a photovoltaic device that comprises forming a photovoltaic layer by stacking a p-layer, an i-layer and an n-layer on top of a substrate, wherein a nitrogen-containing layer comprising nitrogen atoms at an atomic concentration of not less than 1% and not more than 20% and having a crystallization ratio of not less than 0 but less than 3 is formed as the n-layer.

According to the present invention, because the crystallization ratio of the nitrogen-containing layer is low, there is no need to ensure a high hydrogen dilution ratio for the film deposition. Accordingly, a photovoltaic device that exhibits a conversion efficiency as a result of having a high open-circuit voltage can be produced at a rapid rate.

The present invention also provides a process for producing a photovoltaic device that comprises forming a photovoltaic layer by stacking a p-layer, an i-layer and an n-layer on top of a substrate, wherein an interface layer is formed at the interface between the p-layer and the i-layer, and a nitrogen-containing layer comprising nitrogen atoms at an atomic concentration of not less than 1% and not more than 30% is formed as this interface layer.

Furthermore, the present invention also provides a process for producing a photovoltaic device that comprises forming a photovoltaic layer by stacking a p-layer, an i-layer and an n-layer on top of a substrate, wherein an interface layer is formed at the interface between the n-layer and the i-layer, and a nitrogen-containing layer comprising nitrogen atoms at an atomic concentration of not less than 1% and not more than 20% is formed as this interface layer.

According to the present invention, by forming a nitrogen-containing interface layer comprising nitrogen atoms at the atomic concentration mentioned above at either the interface between the p-layer and the i-layer, or the interface between the n-layer and the i-layer, the open-circuit voltage of the photovoltaic device can be increased. In those cases where nitrogen is added to the p-layer or the n-layer, the effect of the nitrogen addition on the carrier concentration must be taken into consideration, but in those cases where an interface layer is formed, there is no need to alter the deposition conditions for the p-layer and the n-layer, thus simplifying adjustment of the deposition parameters.

In the invention described above, the interface layer is preferably an intrinsic semiconductor that comprises nitrogen. Provided the interface layer is an intrinsic semiconductor that comprises nitrogen, adjustment of the deposition parameters can be further simplified, which is advantageous.

In the invention described above, provided the interface layer is formed with a film thickness of not less than 2 nm and not more than 10 nm, the open-circuit voltage of the photovoltaic device can be increased, and as a result, the conversion efficiency can be improved.

In the invention described above, the nitrogen-containing layer is preferably formed by a radio-frequency plasma enhanced CVD method, at a radio frequency of not less than 30 MHz and not more than 100 MHz. At the radio frequency (13.56 MHz) typically used in radio-frequency plasma enhanced CVD methods, the nitrogen is difficult to decompose, and thus the nitrogen atomic concentration incorporated within the nitrogen-containing layer relative to the quantity of supplied nitrogen is extremely low. At frequencies of 27.12 MHz or higher, namely two times the typical 13.56 MHz, improvements start to appear in the decomposition rate. However, if the frequency is too high, then the problem of standing waves causes marked non-uniformity within the plasma, making uniform deposition across a large surface area substrate impossible. Accordingly, by using a radio frequency of not less than 30 MHz and not more than 100 MHz, and preferably not less than 40 MHz and not more than 100 MHz, the nitrogen decomposition rate generated by the plasma increases, and the nitrogen atomic concentration incorporated within the nitrogen-containing layer relative to the quantity of supplied nitrogen also increases. As a result, nitrogen atoms can be incorporated within the nitrogen-containing layer at a high atomic concentration, and the open-circuit voltage can be increased. Furthermore, the nitrogen addition efficiency improves, which has the effect of improving the production efficiency.

According to the present invention, by forming a p-layer or n-layer that comprises a high concentration of nitrogen atoms and also has a crystallization ratio of at least 0 but less than 3, a photovoltaic device can be obtained that exhibits a high open-circuit voltage, thereby exhibits a high conversion efficiency. In this type of photovoltaic device, because the hydrogen dilution ratio need not be high to form the p-layer or n-layer having a high crystallization ratio, the p-layer or n-layer can be deposited rapidly, enabling production to be conducted at a high degree of productivity.

Furthermore, according to the present invention, by forming an interface layer comprising a high concentration of nitrogen atoms at either the interface between the p-layer and the i-layer, or the interface between the n-layer and the i-layer, a photovoltaic device having an increased open-circuit voltage, thereby having improved conversion efficiency can be obtained. In this type of photovoltaic device, because the effect of the nitrogen addition on the carrier concentration need not be considered, adjustment of the deposition parameters can be simplified.

### Brief Description of Drawings

[FIG. 1] A cross-sectional view schematically illustrating the structure of a photovoltaic device according to a first embodiment of the present invention.

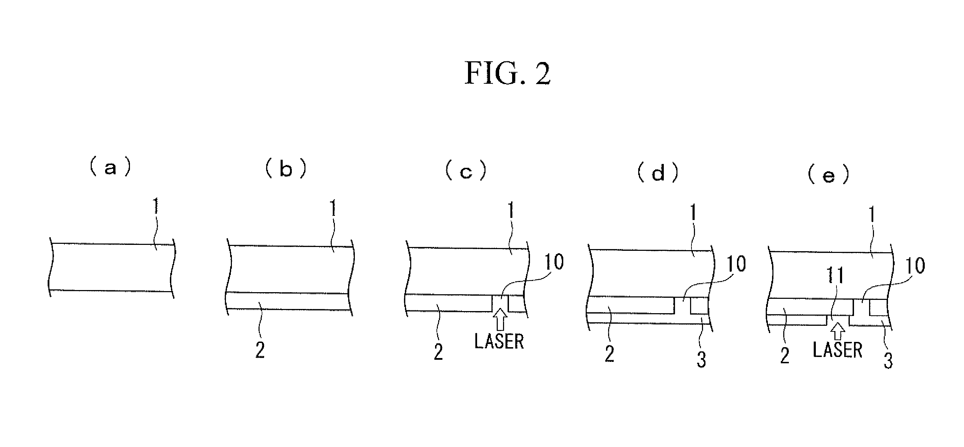

[FIG. 2] A schematic illustration describing one embodiment for producing a solar cell panel, representing a photovoltaic device according to the first embodiment of the present invention.
[FIG. 3] A schematic illustration describing one embodiment for producing a solar cell panel, representing a photovoltaic device according to the first embodiment of the present invention.

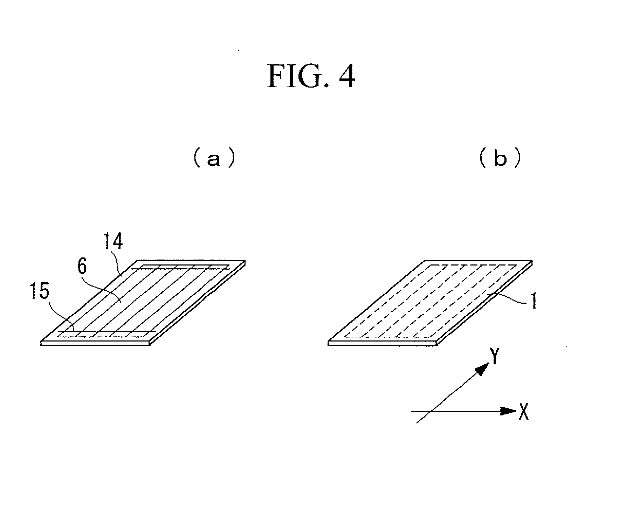

[FIG. 4] A schematic illustration describing one embodiment for producing a solar cell panel, representing a photovoltaic device according to the first embodiment of the present invention.
[FIG. 5] A schematic illustration describing one embodiment for producing a solar cell panel, representing a photovoltaic device according to the first embodiment of the present invention.
[FIG. 6] A graph illustrating the relationship between the N₂ gas concentration and the nitrogen atomic concentration within the p-layer for a photovoltaic device according to the first embodiment.
[FIG. 7] A graph illustrating the relationship between the nitrogen atomic concentration within the p-layer and the crystallization ratio of the p-layer for a photovoltaic device according to the first embodiment.
[FIG. 8] A graph illustrating the relationship between the nitrogen atomic concentration within the p-layer and the open-circuit voltage of the solar cell module for a photovoltaic device according to the first embodiment.
[FIG. 9] A graph illustrating the relationship between the crystallization ratio and the deposition rate for the p-layer of a photovoltaic device according to the first embodiment.
[FIG. 10] A graph illustrating the relationship between the N₂ gas concentration and the nitrogen atomic concentration within the n-layer for a photovoltaic device according to a second embodiment.
[FIG. 11] A graph illustrating the relationship between the nitrogen atomic concentration within the n-layer and the crystallization ratio of the n-layer for a photovoltaic device according to the second embodiment.
[FIG. 12] A graph illustrating the relationship between the nitrogen atomic concentration within the n-layer and the open-circuit voltage of the solar cell module for a photovoltaic device according to the second embodiment.
[FIG. 13] A graph illustrating the relationship between the N₂ gas concentration and the nitrogen atomic concentration within the p/i interface layer for a photovoltaic device according to a third embodiment.
[FIG. 14] A graph illustrating the relationship between the nitrogen atomic concentration within the p/i interface layer and the crystallization ratio of the p/i interface layer for a photovoltaic device according to the third embodiment.
[FIG. 15] A graph illustrating the relationship between the nitrogen atomic concentration within the p/i interface layer and the open-circuit voltage of the solar cell module for a photovoltaic device according to the third embodiment.
[FIG. 16] A graph illustrating the relationship between the film thickness of the p/i interface layer and the open-circuit voltage of the solar cell module for a photovoltaic device according to the third embodiment.
[FIG. 17] A graph illustrating the relationship between the N₂ gas concentration and the nitrogen atomic concentration within the n/i interface layer for a photovoltaic device according to a fourth embodiment.
[FIG. 18] A graph illustrating the relationship between the nitrogen atomic concentration within the n/i interface layer and the crystallization ratio of the n/i interface layer for a photovoltaic device according to the fourth embodiment.
[FIG. 19] A graph illustrating the relationship between the nitrogen atomic concentration within the n/i interface layer and the open-circuit voltage of the solar cell module for a photovoltaic device according to the fourth embodiment.
[FIG. 20] A graph illustrating the relationship between the film thickness of the n/i interface layer and the open-circuit voltage of the solar cell module for a photovoltaic device according to the fourth embodiment.
[FIG. 21] A diagram illustrating the cell structure of a photovoltaic device according to a fifth embodiment of the present invention.
[FIG. 22] A graph illustrating the relationship between the nitrogen atomic concentration within a second cell p-layer and the open-circuit voltage of the solar cell module for a photovoltaic device according to the fifth embodiment of the present invention.
[FIG. 23] A graph illustrating the relationship between the nitrogen atomic concentration within a second cell n-layer and the open-circuit voltage of the solar cell module for a photovoltaic device according to a sixth embodiment of the present invention.
[FIG. 24] A graph illustrating the relationship between the nitrogen atomic concentration within a second cell p/i interface layer and the open-circuit voltage of the solar cell module for a photovoltaic device according to a seventh embodiment of the present invention.
[FIG. 25] A graph illustrating the relationship between the nitrogen atomic concentration within a second cell n/i interface layer and the open-circuit voltage of the solar cell module for a photovoltaic device according to an eighth embodiment of the present invention.
   Explanation of Reference:

- 1:: Substrate
- 2:: Transparent electrode layer
- 3:: Photovoltaic layer
- 4:: Back electrode layer
- 5:: Intermediate contact layer
- 6:: Solar cell module
- 31, 41:: p-layer
- 32, 42:: i-layer
- 33, 43:: n-layer
- 91:: First cell layer
- 92:: Second cell layer
- 100:: Photovoltaic device

### Best Mode for Carrying Out the Invention

### <First Embodiment>

A description of the structure of a photovoltaic device according to a first embodiment of the present invention is presented below.

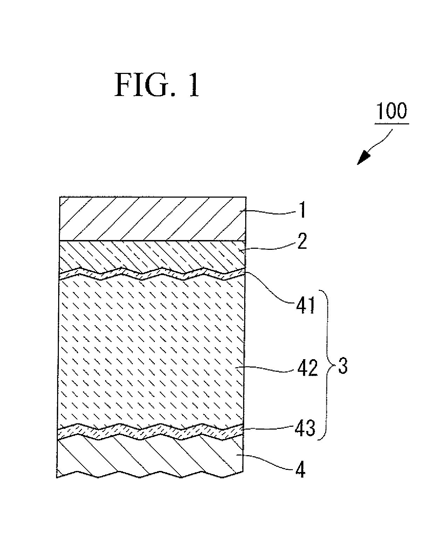

FIG. 1 is a schematic illustration of the structure of a photovoltaic device according to this embodiment. A photovoltaic device 100 is a silicon-based solar cell, and comprises a substrate 1, a transparent electrode layer 2, a photovoltaic layer 3, and a back electrode layer 4. The photovoltaic layer 3 comprises a p-layer 41, an i-layer 42 and an n-layer 43, each composed of a thin film of crystalline silicon, stacked in order from the sunlight-incident side of the device. In the first embodiment, the p-layer 41 is a nitrogen-containing layer that comprises nitrogen atoms at an atomic concentration of not less than 1% and not more than 25%, and has a crystallization ratio of not less than 0 but less than 3. Here, the term "silicon-based" is a generic term that includes silicon (Si), silicon carbide (SiC) and silicon germanium (SiGe). Further, a crystalline silicon system describes a silicon system other than an amorphous silicon system (namely a non-crystalline silicon system), and includes both microcrystalline silicon systems and polycrystalline silicon systems.

A description of the steps for producing a photovoltaic device according to the present embodiment is presented below, using a solar cell panel as an example.

### (1) FIG. 2(a):

A soda float glass substrate (1.4 m × 1.1 m × thickness: 4 mem) is used as the substrate 1. The edges of the substrate are preferably subjected to corner chamfering or R-face chamfering to prevent damage caused by thermal stress or impacts or the like.

### (2) FIG. 2(b):

A transparent electrode film comprising mainly tin oxide (SnO₂) and having a film thickness of approximately not less than 500 nm and not more than 800 nm is deposited as the transparent electrode layer 2, using a thermal CVD apparatus at a temperature of approximately 500°C. During this deposition, a texture comprising suitable unevenness is formed on the surface of the transparent electrode film. In addition to the transparent electrode film, the transparent electrode layer 2 may include an alkali barrier film (not shown in the figure) formed between the substrate 1 and the transparent electrode film. The alkali barrier film is formed using a thermal CVD apparatus at a temperature of approximately 500°C to deposit a silicon oxide film (SiO₂) having a film thickness of not less than 50 nm and not more than 150 nm.

### (3) FIG. 2(c):

Subsequently, the substrate 1 is mounted on an X-Y table, and the first harmonic of a YAG laser (1064 nm) is irradiated onto the surface of the transparent electrode layer, as shown by the arrow in the figure. The laser power is adjusted to ensure an appropriate process speed, and the transparent electrode film is then moved in a direction perpendicular to the direction of the series connection of the electric power generation cells, thereby causing a relative movement between the substrate 1 and the laser light, and conducting laser etching across a strip having a predetermined width of approximately 6 mm to 15 mm to form a slot 10.

### (4) FIG. 2(d):

Using a plasma enhanced CVD apparatus, the p-layer 41, the i-layer 42 and the n-layer 43 are stacked sequentially on the sunlight-incident side of the transparent electrode layer 2, thus forming the photovoltaic layer 3.

In the p-layer deposition chamber, the substrate is heated to approximately 200°C. SiH₄ gas, H₂ gas, B₂H₆ gas and N₂ gas are then introduced into the p-layer deposition chamber as raw material gases. At this point, in consideration of the deposition rate, the hydrogen dilution ratio H₂/SiH₄ is preferably set to approximately 100. The N₂ gas is introduced at a flow rate that yields a N₂ gas concentration N₂/(N₂+SiH₄) of not less than 3% and not more than 50%. Under conditions including a deposition pressure of not more than 3,000 Pa and a frequency of not less than 30 MHz and not more than 100 MHz, a nitrogen-containing B-doped silicon p-layer is deposited at a thickness of not less than 10 nm and not more than 50 nm.
By conducting deposition under the above conditions, the p-layer is formed as a nitrogen-containing layer comprising nitrogen atoms at an atomic concentration of not less than 1% and not more than 25% and having a crystallization ratio of not less than 0 but less than 3.

Next, SiH₄ gas and H₂ gas are introduced into the i-layer deposition chamber as raw material gases. A crystalline silicon i-layer having a thickness of not less than 1.2 µm and not more than 3.0 µm is deposited under conditions including a deposition pressure of not more than 3,000 Pa, a substrate temperature of approximately 200°C, and a frequency of not less than 40 MHz and not more than 100 MHz.

Subsequently, SiH₄ gas, H₂ gas and PH₃ gas are introduced into the n-layer deposition chamber as raw material gases, and a P-doped crystalline silicon n-layer having a thickness of not less than 20 nm and not more than 50 nm is deposited under conditions including a deposition pressure of not more than 3,000 Pa, a substrate temperature of approximately 200°C, and a frequency of not less than 40 MHz and not more than 100 MHz.

### (5) FIG. 2(e):

The substrate 1 is mounted on an X-Y table, and the second harmonic of a laser diode excited YAG laser (532 nm) is irradiated onto the film surface of the photovoltaic layer 3, as shown by the arrow in the figure. With the pulse oscillation set to not less than 10 kHz and not more than 20 kHz, the laser power is adjusted so as to achieve a suitable process speed, and laser etching is conducted at a point approximately 100 µm to 150 µm to the side of the laser etching line within the transparent electrode layer 2, so as to form a slot 11. The laser may also be irradiated from the side of the substrate 1. In this case, because the high vapor pressure generated by the energy absorbed by the photovoltaic layer 3 can be utilized, more stable laser etching processing can be performed. The position of the laser etching line is determined with due consideration of positioning tolerances, so as not to overlap with the previously formed etching line.

### (6) FIG. 3(a):

Using a sputtering apparatus, an Ag film and a Ti film are deposited sequentially as the back electrode layer 4 under a reduced pressure atmosphere and at a temperature of approximately 150°C. In this embodiment, the back electrode layer 4 is formed by sequentially stacking an Ag film having a thickness of not less than 200 nm and not more than 500 nm, and a highly corrosion-resistant Ti film having a thickness of not less than 10 nm and not more than 20 nm which acts as a protective film. In order to reduce the contact resistance between the n-layer 43 and the back electrode layer 4 and improve the reflectance, a GZO (Ga-doped ZnO) film with a film thickness of not less than 50 nm and not more than 100 nm may be deposited between the photovoltaic layer 3 and the back electrode layer 4 using a sputtering apparatus. Furthermore, an Al film of not less than 250 nm and not more than 350 nm may be used instead of the Ti film. By using Al instead of Ti, the material costs can be reduced while maintaining the anticorrosion effect.

### (7) FIG. 3(b):

The substrate 1 is mounted on an X-Y table, and the second harmonic of a laser diode excited YAG laser (532 nm) is irradiated onto the substrate 1, as shown by the arrow in the figure. The laser light is absorbed by the photovoltaic layer 3, and by utilizing the high gas vapor pressure generated at this point, the back electrode layer 4 is removed by explosive fracture. With the pulse oscillation set to not less than 1 kHz and not more than 10 kHz, the laser power is adjusted so as to achieve a suitable process speed, and laser etching is conducted at a point approximately 250 µm to 400 µm to the side of the laser etching line within the transparent electrode layer 2, so as to form a slot 12.

### (8) FIG. 3(c):

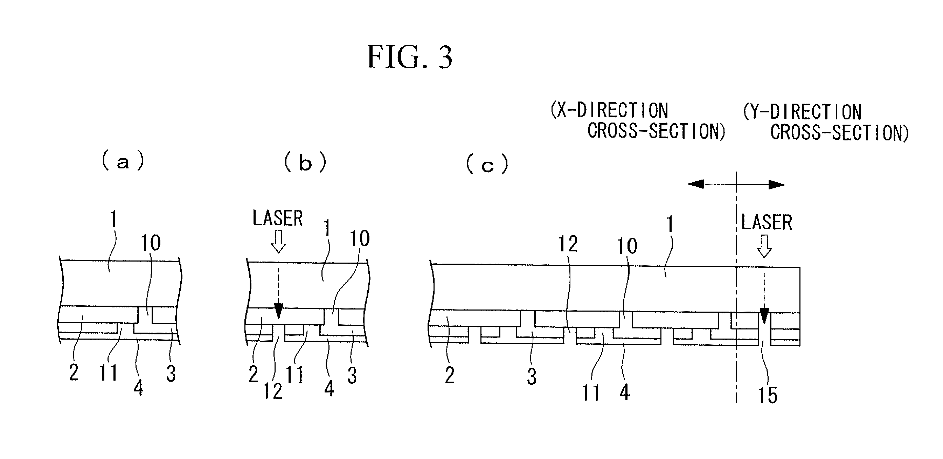

The electric power generation region is then compartmentalized, by using laser etching to remove the effect wherein the serially connected portions at the film edges near the edges of the substrate are prone to short circuits. The substrate 1 is mounted on an X-Y table, and the second harmonic of a laser diode excited YAG laser (532 nm) is irradiated onto the substrate 1. The laser light is absorbed by the transparent electrode layer 2 and the photovoltaic layer 3, and by utilizing the high gas vapor pressure generated at this point, the back electrode layer 4 is removed by explosive fracture. Thereby, the back electrode layer 4, the photovoltaic layer 3 and the transparent electrode layer 2 are removed. With the pulse oscillation set to not less than 1 kHz and not more than 10 kHz, the laser power is adjusted so as to achieve a suitable process speed, and laser etching is conducted at a point approximately 5 mm to 20 mm from the edge of the substrate 1, so as to form an X-direction insulation slot 15 as illustrated in FIG. 3(c). A Y-direction insulation slot need not be provided at this point, because a film surface polishing and removal treatment is conducted on the peripheral regions of the substrate 1 in a later step.

Completing the etching of the insulation slot 15 at a position 5 to 10 mm from the edge of the substrate 1 is preferred, as it ensures that the insulation slot 15 is effective in inhibiting external moisture from entering the interior of the solar cell module 6 via the edges of the solar cell panel.

Although the laser light used in the steps until this point has been specified as YAG laser light, light from a YVO4 laser or fiber laser or the like may also be used in a similar manner.

### (9) FIG. 4(a):

In order to ensure favorable adhesion and sealing of a backing sheet 24 via EVA or the like in a subsequent step, the stacked films around the periphery of the substrate 1 (in a peripheral region 14) are removed, as they tend to be uneven and prone to peeling. Grinding or blast polishing or the like is used to remove the back electrode layer 4, the photovoltaic layer 3, and the transparent electrode layer 2 from a region that is 5 mm to 20 mm from the edge around the entire periphery of the substrate 1, is closer to the substrate edge than the insulation slot 15 provided in the above step of FIG. 3(c) in the X direction, and is closer to the substrate edge than the slot 10 near the substrate edge in the Y direction. Grinding debris or abrasive grains are removed by washing the substrate 1.

### (10) FIG. 4(b):

A terminal box attachment portion is prepared by providing an open through-window in the backing sheet 24 and exposing a collecting plate. A plurality of layers of an insulating material are provided in this open through-window portion in order to prevent external moisture and the like entering the solar cell module.

Processing is conducted so as to enable current collection, using a copper foil, from the series-connected solar cell electric power generation cell at one end, and the solar cell electric power generation cell at the other end, in order to enable electric power to be extracted from a terminal box portion on the rear surface of the solar cell panel. In order to prevent short circuits between the copper foil and the various portions, an insulating sheet that is wider than the width of the copper foil is provided.

Following arrangement of the collecting copper foil and the like at predetermined positions, the entire solar cell module 6 is covered with a sheet of an adhesive filling material such as EVA (ethylene-vinyl acetate copolymer) arranged so as not to protrude beyond the substrate 1.

A backing sheet 24 with a superior waterproofing effect is positioned on top of the EVA. In this embodiment, in order to achieve a superior waterproofing and moisture-proofing effect, the backing sheet 24 is formed as a three-layer structure comprising a PET sheet, an Al foil, and a PET sheet.

The structure comprising the components up to and including the backing sheet 24 arranged in predetermined positions is subjected to internal degassing under a reduced pressure atmosphere and pressing at approximately 150°C to 160°C using a laminator, thereby causing cross-linking of the EVA that tightly seals the structure.

### (11) FIG. 5(a):

A terminal box 23 is attached to the rear surface of the solar cell module 6 using an adhesive.

### (12) FIG. 5(b):

The copper foil and an output cable from the terminal box 23 are connected using solder or the like, and the interior of the terminal box is filled and sealed with a sealant (a potting material). This completes the production of the solar cell panel 50.

### (13) FIG. 5(c):

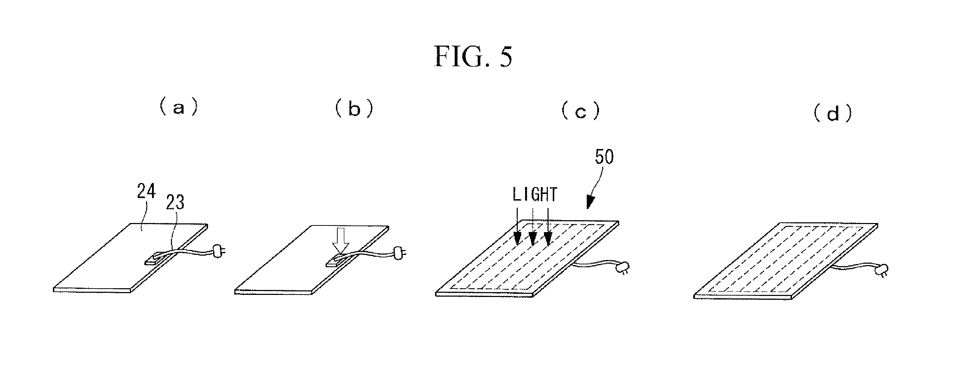

The solar cell panel 50 formed via the steps up to and including FIG. 5(b) is then subjected to an electric power generation test, as well as other tests for evaluating specific performance factors. The electric power generation test is conducted using a solar simulator that emits a standard sunlight of AM 1.5 (1,000 W/m²).

### (14) FIG. 5(d):

In tandem with the electric power generation test (FIG. 5(c)), a variety of specific performance factors including the external appearance are evaluated.

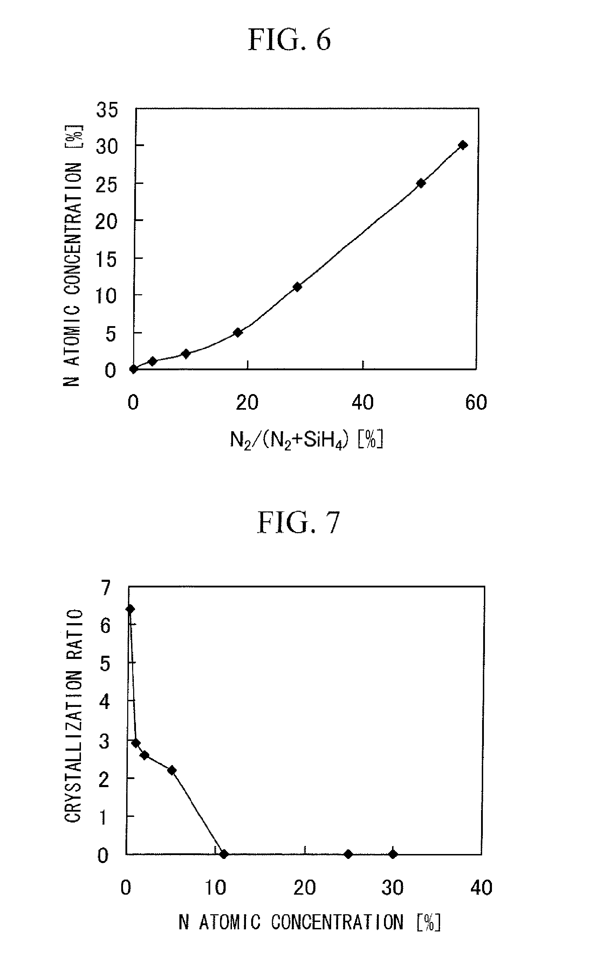

FIG. 6 is a graph illustrating the relationship between the N₂ gas concentration and the nitrogen atomic concentration within the p-layer. In this figure, the horizontal axis represents the N₂ gas concentration, and the vertical axis represents the nitrogen atomic concentration. The deposition conditions for the p-layer included a hydrogen dilution ratio of 100-fold, a deposition pressure of 67 Pa, a deposition temperature of 200°C, a radio frequency of 100 MHz, an applied electric power of 75 W, and a film thickness of 30 nm. The nitrogen atomic concentration was measured by X-ray photoelectron spectroscopic analysis (XPS). As the N₂ gas concentration was increased, the nitrogen atomic concentration within the p-layer increased. At a N₂ gas concentration of not less than 3% and not more than 50%, the nitrogen atomic concentration within the p-layer was not less than 1% and not more than 25%, confirming that a large quantity of nitrogen atoms had been incorporated within the p-layer.

FIG. 7 is a graph illustrating the relationship between the nitrogen atomic concentration within the p-layer and the crystallization ratio of the p-layer. In this figure, the horizontal axis represents the nitrogen atomic concentration, and the vertical axis represents the crystallization ratio. The crystallization ratio was high when no nitrogen was added to the p-layer, but when the nitrogen atomic concentration was 1% or greater, the crystallization ratio decreased to less than 3. When the nitrogen atomic concentration exceeded 10%, the crystallization ratio fell to 0, namely, an amorphous state.

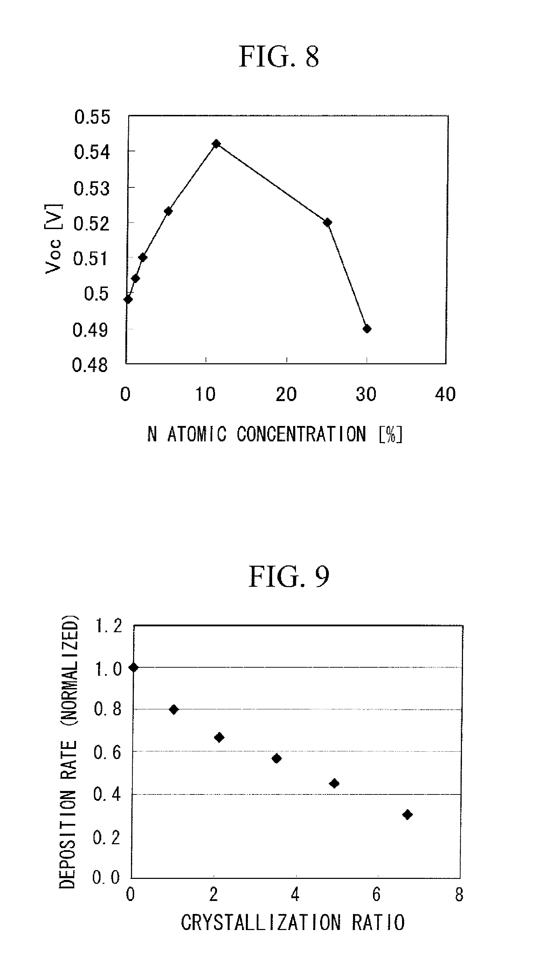

FIG. 8 is a graph illustrating the relationship between the nitrogen atomic concentration within the p-layer and the open-circuit voltage of the solar cell module. In this figure, the horizontal axis represents the nitrogen atomic concentration, and the vertical axis represents the open-circuit voltage. The deposition conditions for the i-layer included a hydrogen dilution ratio of 21.4-fold, a deposition pressure of 400 Pa, a deposition temperature of 200°C, a radio frequency of 100 MHz, an applied electric power of 30 W, and a film thickness of 2 µm. The deposition conditions for the n-layer included a hydrogen dilution ratio of 100-fold, a deposition pressure of 93 Pa, a deposition temperature of 170°C, a radio frequency of 60 MHz, an applied electric power of 15 W, and a film thickness of 30 nm. A solar cell module in which the nitrogen atomic concentration within the p-layer was not less than 1% and not more than 25% exhibited a higher open-circuit voltage than a solar cell module in which no nitrogen was added. In contrast, if the nitrogen atomic concentration exceeded 25%, then the open-circuit voltage actually decreased. In the solar cell module of FIG. 8, the substrate temperature was set to 170°C during deposition of the n-layer, but a similar effect was obtained at a substrate temperature of 200°C.

FIG. 9 is a graph illustrating the relationship between the crystallization ratio and the deposition rate for the p-layer. In this figure, the horizontal axis represents the crystallization ratio, and the vertical axis represents the deposition rate normalized relative to a deposition rate of 1 for the case when the crystallization ratio is 0. The deposition rate decreased as the crystallization ratio increased. When the crystallization ratio for the p-layer was less than 3, the deposition rate was at least 0.6. Accordingly, under these conditions, a p-layer containing nitrogen was able to be deposited at a high deposition rate.

### <Second Embodiment>

In a photovoltaic device according to a second embodiment of the present invention, the n-layer 43 shown in FIG. 1 is formed as a nitrogen-containing layer that comprises nitrogen atoms at an atomic concentration of not less than 1% and not more than 20% and has a crystallization ratio of not less than 0 but less than 3.

A description of the steps for forming the photovoltaic layer of a photovoltaic device according to the present embodiment is presented below, using a solar cell panel as an example. The other steps for producing the solar cell panel are substantially the same as those described for the first embodiment, and their description is therefore omitted.

Using a plasma enhanced CVD apparatus, SiH₄ gas, H₂ gas and B₂H₆ gas are introduced into the p-layer deposition chamber as raw material gases, and a B-doped crystalline silicon p-layer having a thickness of not les than 10 nm and not more than 50 nm is deposited under conditions including a deposition pressure of 3,000 Pa, a substrate temperature of approximately 200°C, and a frequency of not less than 40 MHz and not more than 100 MHz.

A crystalline silicon i-layer is then deposited under the same conditions as the first embodiment.

Subsequently, SiH₄ gas, H₂ gas, PH₃ gas and N₂ gas are introduced into the n-layer deposition chamber as raw material gases. At this point, in consideration of the deposition rate, the hydrogen dilution ratio H₂/SiH₄ is preferably set to approximately 100. The N₂ gas is introduced at a flow rate that yields a N₂ gas concentration of not less than 14% and not more than 63%. Under conditions including a deposition pressure of not more than 3,000 Pa, a substrate temperature of approximately 170°C, and a frequency of not less than 30 MHz and not more than 100 MHz, a nitrogen-containing P-dope silicon n-layer is deposited at a thickness of not less than 20 nm and not more than 50 nm. By conducting deposition under the above conditions, the n-layer is formed as a nitrogen-containing layer comprising nitrogen atoms at an atomic concentration of not less than 1% and not more than 20% and having a crystallization ratio of not less than 0 but less than 3.

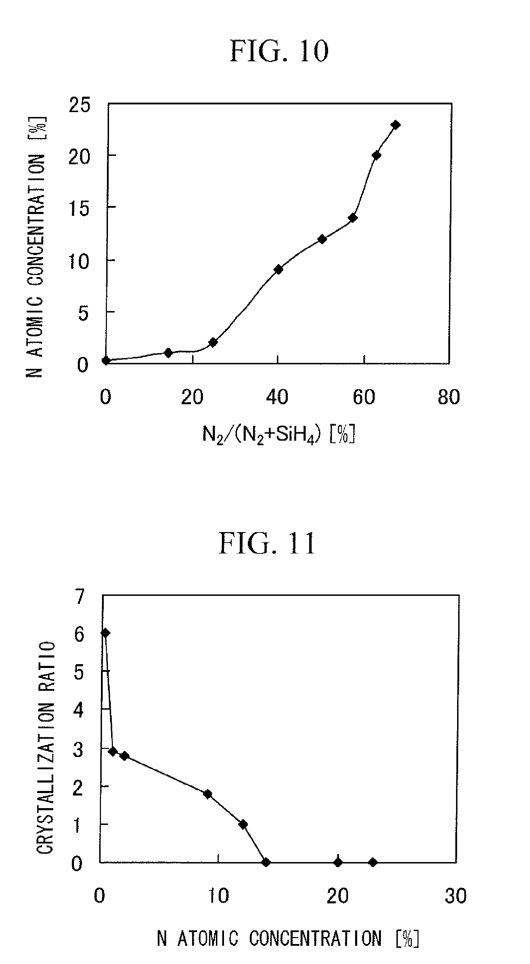

FIG. 10 is a graph illustrating the relationship between the N₂ gas concentration and the nitrogen atomic concentration within the n-layer. In this figure, the horizontal axis represents the N₂ gas concentration, and the vertical axis represents the nitrogen atomic concentration. The deposition conditions for the n-layer included a hydrogen dilution ratio of 100-fold, a deposition pressure of 93 Pa, a deposition temperature of 170°C, a radio frequency of 60 MHz, an applied electric power of 15 W, and a film thickness of 30 nm. As the N₂ gas proportion was increased, the nitrogen atomic concentration within the film increased. At a N₂ gas concentration of not less than 14% and not more than 63%, the nitrogen atomic concentration was not less than 1% and not more than 20%, confirming that a large quantity of nitrogen atoms had been incorporated within the n-layer. In the present embodiment, the substrate temperature was set to 170°C during deposition of the n-layer, but a similar effect was obtained at a substrate temperature of 200°C.

FIG. 11 is a graph illustrating the relationship between the nitrogen atomic concentration within the n-layer and the crystallization ratio of the n-layer. In this figure, the horizontal axis represents the nitrogen atomic concentration, and the vertical axis represents the crystallization ratio. The crystallization ratio was high when no nitrogen was added to the n-layer, but when the nitrogen atomic concentration was 1% or greater, the crystallization ratio decreased to less than 3. When the nitrogen atomic concentration was 14% or greater, the crystallization ratio fell to 0, meaning an amorphous film was obtained.

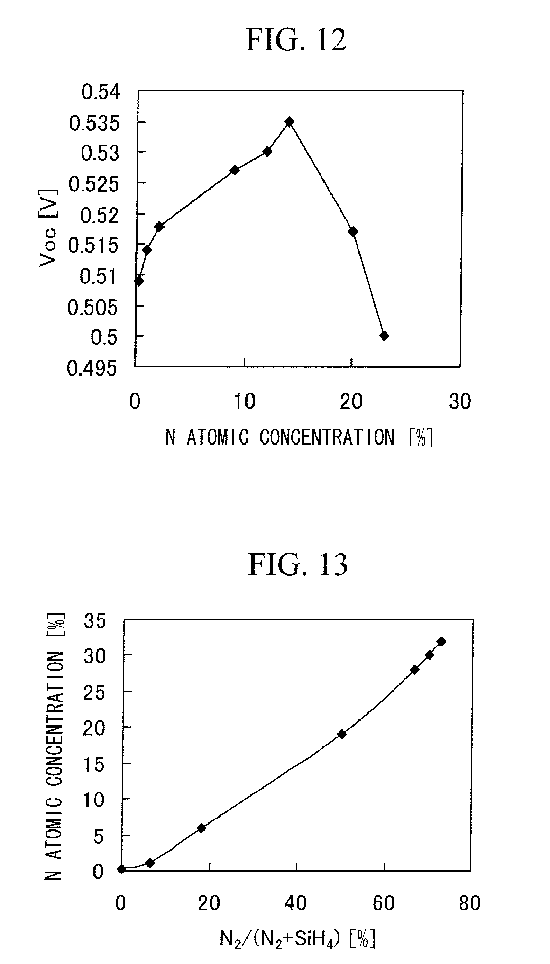

FIG. 12 is a graph illustrating the relationship between the nitrogen atomic concentration within the n-layer and the open-circuit voltage of the solar cell module. In this figure, the horizontal axis represents the nitrogen atomic concentration, and the vertical axis represents the open-circuit voltage. The deposition conditions for the p-layer, included a hydrogen dilution ratio of 100-fold, a deposition pressure of 67 Pa, a deposition temperature of 200°C, a radio frequency of 100 MHz, an applied electric power of 75 W, and a film thickness of 30 nm, whereas the deposition conditions for the i-layer included a hydrogen dilution ratio of 21.4-fold, a deposition pressure of 400 Pa, a deposition temperature of 200°C, a radio frequency of 100 MHz, an applied electric power of 30 W, and a film thickness of 2 µm. A solar cell module in which the nitrogen atomic concentration within the n-layer was not less than 1% and not more than 20% exhibited a higher open-circuit voltage than a solar cell module in which no nitrogen was added. In contrast, if the nitrogen atomic concentration exceeded 20%, then the open-circuit voltage actually decreased.

In a similar manner to the first embodiment, the deposition rate for the nitrogen-containing n-layer decreased as the crystallization ratio increased. By ensuring that the crystallization ratio for the n-layer was less than 3, deposition was able to be conducted at a high deposition rate.

### <Third Embodiment>

In a photovoltaic device according to a third embodiment of the present invention, a p/i interface layer composed of an intrinsic semiconductor layer comprising nitrogen atoms at an atomic concentration of not less than 1% and not more than 30% is formed between the p-layer 41 and the i-layer 42 in FIG. 1.

A description of the steps for forming the photovoltaic layer of a photovoltaic device according to the third embodiment is presented below, using a solar cell panel as an example. The other steps for producing the solar cell panel are substantially the same as those described for the first embodiment, and their description is therefore omitted.

Using a plasma enhanced CVD apparatus, a crystalline silicon p-layer is deposited under the same conditions as the second embodiment.

Following deposition of the p-layer, supply of the B₂H₆ gas is halted, and N₂ gas is supplied to the p-layer deposition chamber. The N₂ gas is introduced at a flow rate that yields a N₂ gas concentration of not less than 6% and not more than 70%. Using the same substrate temperature as that used during deposition of the p-layer, a nitrogen-containing silicon p/i interface layer having a thickness of not less than 2 nm and not more than 10 nm is deposited under conditions including a deposition pressure of not more than 3,000 Pa and a frequency of not less than 30 MHz and not more than 100 MHz. By conducting deposition under the above conditions, the p/i interface layer is formed as a nitrogen-containing layer comprising nitrogen atoms at an atomic concentration of not less than 1% and not more than 30%.

Subsequently, a crystalline silicon i-layer and a crystalline silicon n-layer are deposited under the same conditions as the first embodiment.

FIG. 13 is a graph illustrating the relationship between the N₂ gas concentration and the nitrogen atomic concentration within the p/i interface layer. In this figure, the horizontal axis represents the N₂ gas concentration, and the vertical axis represents the nitrogen atomic concentration. The deposition conditions for the p/i interface layer included a hydrogen dilution ratio of 100-fold, a deposition pressure of 67 Pa, a deposition temperature of 200°C, a radio frequency of 100 MHz, an applied electric power of 75 W, and a film thickness of 4 nm. As the N₂ gas proportion was increased, the nitrogen atomic concentration within the film increased. At a N₂ gas concentration of not less than 6% and not more than 70%, the nitrogen atomic concentration was not less than 1% and not more than 30%, confirming that a p/i interface layer comprising a large quantity of nitrogen atoms had been formed.

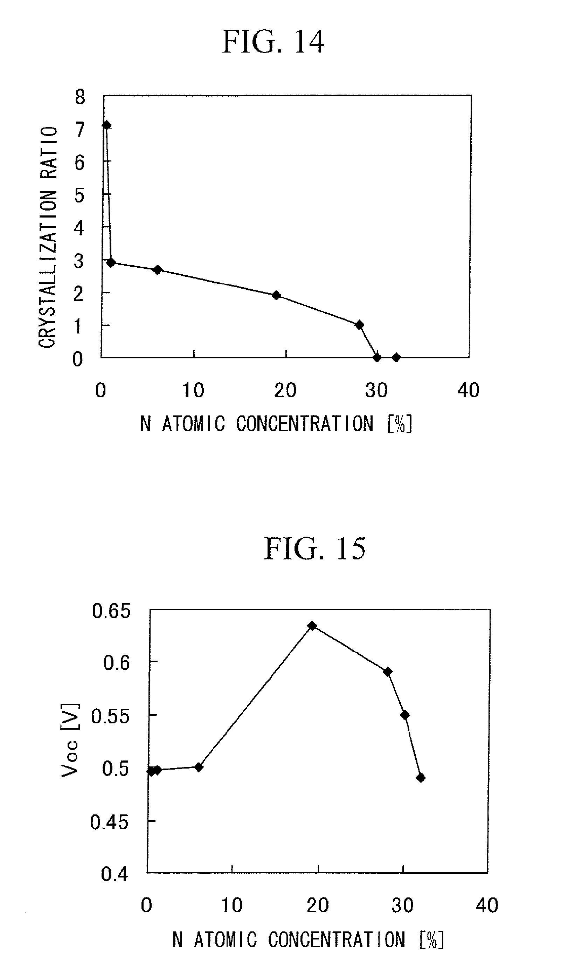

FIG. 14 is a graph illustrating the relationship between the nitrogen atomic concentration within the p/i interface layer and the crystallization ratio of the p/i interface layer. In this figure, the horizontal axis represents the nitrogen atomic concentration, and the vertical axis represents the crystallization ratio. The crystallization ratio was high when no nitrogen was added to the p/i interface layer, but the crystallization ratio of the p/i interface layer decreased upon addition of nitrogen. When the nitrogen atomic concentration was 30% or greater, the crystallization ratio fell to 0, meaning an amorphous film was obtained.

FIG. 15 is a graph illustrating the relationship between the nitrogen atomic concentration within the p/i interface layer and the open-circuit voltage of the solar cell module. In this figure, the horizontal axis represents the nitrogen atomic concentration, and the vertical axis represents the open-circuit voltage. The deposition conditions for the p-layer included a hydrogen dilution ratio of 100-fold, a deposition pressure of 67 Pa, a deposition temperature of 200°C, a radio frequency of 100 MHz, an applied electric power of 75 W, and a film thickness of 30 nm, the deposition conditions for the i-layer included a hydrogen dilution ratio of 21.4-fold, a deposition pressure of 400 Pa, a deposition temperature of 200°C, a radio frequency of 100 MHz, an applied electric power of 30 W, and a film thickness of 2 µm, and the deposition conditions for the n-layer included a hydrogen dilution ratio of 100-fold, a deposition pressure of 93 Pa, a deposition temperature of 170°C, a radio frequency of 60 MHz, an applied electric power of 15 W, and a film thickness of 30 nm. A solar cell module in which the nitrogen atomic concentration within the p/i interface layer was not less than 1% and not more than 30% exhibited a higher open-circuit voltage than a solar cell module in which no nitrogen was added. In contrast, if the nitrogen atomic concentration exceeded 30%, then the open-circuit voltage actually decreased. In the present embodiment, the substrate temperature was set to 170°C during deposition of the n-layer, but a similar effect was obtained at a substrate temperature of 200°C.

As described above, by forming a p/i interface layer having a nitrogen atomic concentration of not less than 1% and not more than 30% and also having a low crystallization ratio, the open-circuit voltage of the solar cell module was able to be increased.

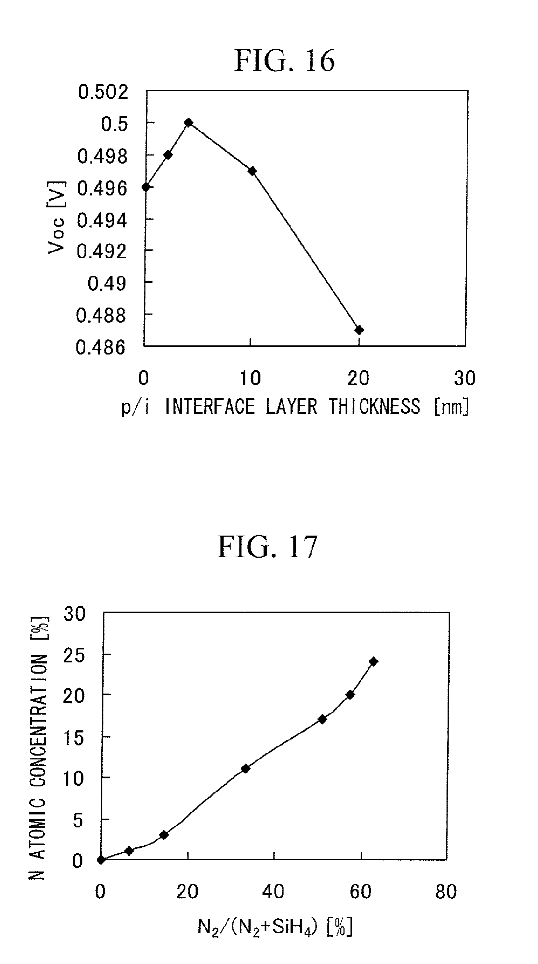

FIG. 16 is a graph illustrating the relationship between the film thickness of the p/i interface layer and the open-circuit voltage of the solar cell module. In this figure, the horizontal axis represents the film thickness of the p/i interface layer, and the vertical axis represents the open-circuit voltage. The nitrogen atom concentration of the p/i interface layer in the figure was 6%. When the film thickness of the p/i interface layer was not less than 2 nm and not more than 10 nm, the open-circuit voltage was higher than that obtained in the case where no p/i interface layer was provided (namely, when the p/i interface layer thickness was 0 nm).
In this manner, by setting the film thickness of the p/i interface layer to a value not less than 2 nm and not more than 10 nm, an increase in the open-circuit voltage was obtained due to a widening of the band gap.

### <Fourth Embodiment>>

In a photovoltaic device according to a fourth embodiment of the present invention, an n/i interface layer composed of an intrinsic semiconductor layer comprising nitrogen atoms at an atomic concentration of not less than 1% and not more than 20% is formed between the i-layer 42 and the n-layer 43 in FIG. 1.

A description of the steps for forming the photovoltaic layer of a photovoltaic device according to the fourth embodiment is presented below, using a solar cell panel as an example. The other steps for producing the solar cell panel are substantially the same as those described for the first embodiment, and their description is therefore omitted.

Using a plasma enhanced CVD apparatus, a crystalline silicon p-layer and a crystalline silicon i-layer are deposited under the same conditions as the second embodiment.

Subsequently, an n/i interface layer is deposited in the n-layer deposition chamber. SiH₄ gas, H₂ gas and N₂ gas are introduced as raw material gases. The N₂ gas is introduced at a flow rate that yields a N₂ gas concentration of not less than 6% and not more than 57%. Under conditions including a deposition pressure of not more than 3,000 Pa, a substrate temperature of approximately 170°C, and a frequency of not less than 30 MHz and not more than 100 MHz, a nitrogen-containing silicon n/i interface layer is deposited at a thickness of not less than 2 nm and not more than 10 nm. By conducting deposition under the above conditions, the n/i interface layer is formed as a nitrogen-containing layer comprising nitrogen atoms at an atomic concentration of not less than 1% and not more than 20%.

Subsequently, the supply of the N₂ gas is halted, and B₂H₆ gas is supplied to the n-layer deposition chamber. A crystalline silicon n-layer is then deposited under the same conditions as the first embodiment.

FIG. 17 is a graph illustrating the relationship between the N₂ gas concentration and the nitrogen atomic concentration within the n/i interface layer. In this figure, the horizontal axis represents the N₂ gas concentration, and the vertical axis represents the nitrogen atomic concentration. The deposition conditions for the n/i interface layer included a hydrogen dilution ratio of 100-fold, a deposition pressure of 93 Pa, a deposition temperature of 170°C, a radio frequency of 60 MHz, an applied electric power of 15 W, and a film thickness of 4 nm. At a N₂ gas concentration of not less than 6% and not more than 57%, the nitrogen atomic concentration was not less than 1% and not more than 20%, confirming that a large quantity of nitrogen atoms had been incorporated within the n/i interface layer. In the present embodiment, the substrate temperature was set to 170°C during deposition of the n-layer, but a similar effect was obtained at a substrate temperature of 200°C.

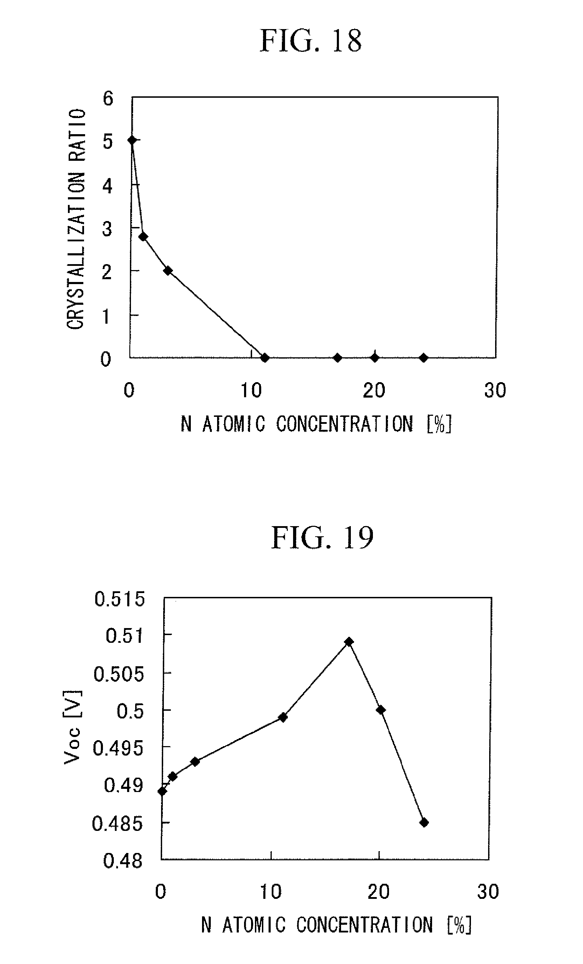

FIG. 18 is a graph illustrating the relationship between the nitrogen atomic concentration within the n/i interface layer and the crystallization ratio of the n/i interface layer. In this figure, the horizontal axis represents the nitrogen atomic concentration, and the vertical axis represents the crystallization ratio. The crystallization ratio was high when no nitrogen was added to the n/i interface layer, but the crystallization ratio of the n/i interface layer decreased upon addition of nitrogen. When the nitrogen atomic concentration was 11% or greater, the crystallization ratio fell to 0, meaning an amorphous film was obtained.

FIG. 19 is a graph illustrating the relationship between the nitrogen atomic concentration within the n/i interface layer and the open-circuit voltage of the solar cell module. In this figure, the horizontal axis represents the nitrogen atomic concentration, and the vertical axis represents the open-circuit voltage. The deposition conditions for the p-layer, the i-layer and the n-layer were the same as those described for the third embodiment. A solar cell module in which the nitrogen atomic concentration within the p/i interface layer was not less than 1% and not more than 20% exhibited a higher open-circuit voltage than a solar cell module in which no nitrogen was added. In contrast, if the nitrogen atomic concentration exceeded 20%, then the open-circuit voltage actually decreased.

As described above, by forming an n/i interface layer having a nitrogen atomic concentration of not less than 1% and not more than 20% and also having a low crystallization ratio, the open-circuit voltage of the solar cell nodule was able to be increased.

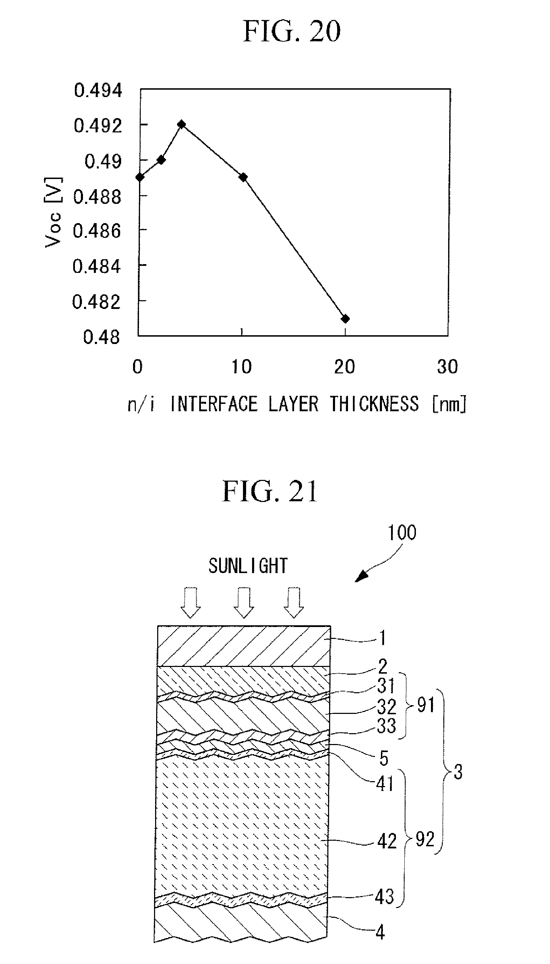

FIG. 20 is a graph illustrating the relationship between the film thickness of the n/i interface layer and the open-circuit voltage of the solar cell module. In this figure, the horizontal axis represents the film thickness of the n/i interface layer, and the vertical axis represents the open-circuit voltage. The nitrogen atom concentration of the n/i interface layer in the figure was 11%. When the film thickness of the n/i interface layer was not less than 2 nm and not more than 10 nm, the open-circuit voltage was higher than that obtained in the case where no n/i interface layer was provided.

In this manner, by setting the film thickness of the n/i interface layer to a value not less than 2 nm and not more than 10 nm, an increase in the open-circuit voltage was obtained due to a widening of the band gap.

### <Fifth Embodiment>

A description of the structure of a photovoltaic device according to a fifth embodiment of the present invention is presented below.
FIG. 21 is a schematic illustration of the structure of a photovoltaic device according to the fifth embodiment. This photovoltaic device 100 is a tandem-type silicon-based solar cell. The photovoltaic layer 3 comprises a first cell layer 91 and a second cell layer 92 stacked in order on the substrate 1. The first cell layer 91 comprises a p-layer 31, an i-layer 32 and an n-layer 33, each composed of a thin film of amorphous silicon, stacked in order from the sunlight-incident side of the device. The second cell layer 92 comprises a p-layer 41, an i-layer 42 and an n-layer 43 stacked in order from the sunlight-incident side of the device. In the fifth embodiment, the p-layer 41 of the second cell layer is a nitrogen-containing layer that comprises nitrogen atoms at an atomic concentration of not less than 1% and not more than 25%, and has a crystallization ratio of not less than 0 but less than 3.

A description of the steps for forming the photovoltaic layer of a photovoltaic device according to the fifth embodiment is presented below, using a solar cell panel as an example. The other steps for producing the solar cell panel are substantially the same as those described for the first embodiment, and their description is therefore omitted.

In the case of the first cell layer 91 of the photovoltaic layer 3, SiH₄ gas and H₂ gas are used as the main raw material gases, and the p-layer 31, the i-layer 32 and the n-layer 33 are deposited in order from the sunlight-incident side of the transparent electrode layer 2, under conditions including a reduced pressure atmosphere of not less than 30 Pa and not more than 1,000 Pa, a substrate temperature of approximately 200°C, and a frequency of not less than 40 MHz and not more than 100 MHz. The p-layer 31 is deposited by introducing B₂H₆ gas as an additional raw material gas, and is formed as an amorphous B-doped silicon film having a film thickness of not less than 10 nm and not more than 30 nm. The i-layer 32 is an amorphous silicon film, and has a film thickness of not less than 200 nm and not more than 350 nm. The n-layer 33 is deposited by introducing PH₃ gas as an additional raw material gas, and is formed as an amorphous P-doped silicon film having a film thickness of not less than 30 nm and not more than 50 nm. A buffer layer may be provided between the p-layer 31 and the i-layer 32 to improve the interface properties.

A p-layer, an i-layer, and an n-layer are then deposited in order on top of the first cell layer 91 using the same steps as the first embodiment, thus forming the second cell layer 92.

In this embodiment, an intermediate contact layer 5 that functions as a semi-reflective film for improving the contact properties and achieving electrical current consistency may be provided between the first cell layer 91 and the second cell layer 92. For example, a GZO (Ga-doped ZnO) film with a film thickness of not less than 20 nm and not more than 100 nm may be deposited as the intermediate contact layer 5 using a sputtering apparatus.

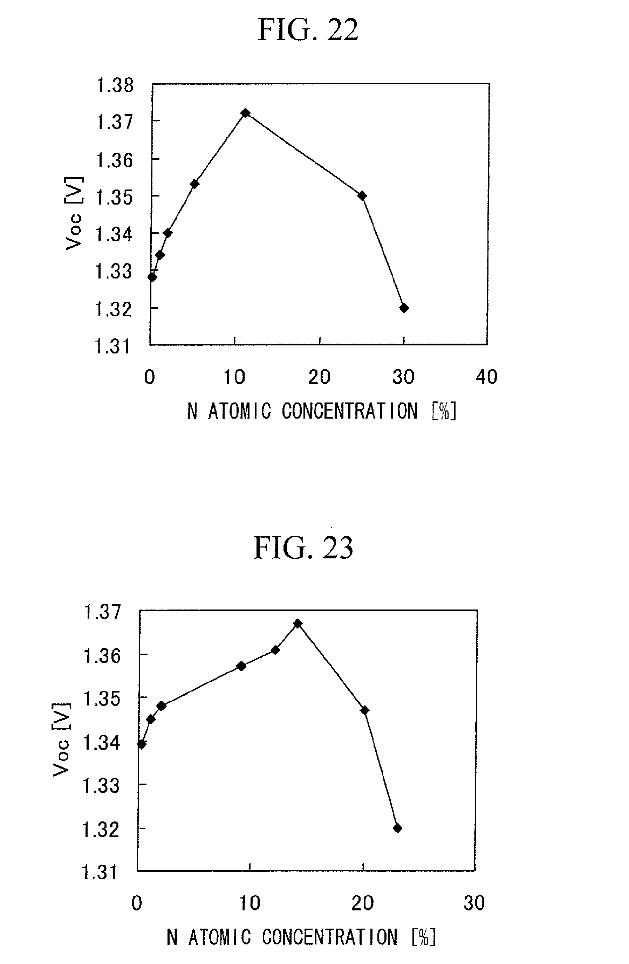

FIG. 22 is a graph illustrating the relationship between the nitrogen atomic concentration within the p-layer of the second cell layer and the open-circuit voltage of the solar cell module. In this figure, the horizontal axis represents the nitrogen atomic concentration, and the vertical axis represents the open-circuit voltage. Under the deposition conditions described above, the first cell layer was deposited with a p-layer thickness of 8 nm, an i-layer thickness of 300 nm and an n-layer thickness of 40 nm. The deposition conditions for the second cell layer were the same as those described for the first embodiment.
Even in a tandem-type solar cell module, when the nitrogen atomic concentration within the p-layer was not less than 1% and not more than 25%, the open-circuit voltage was higher than that for a solar cell module in which no nitrogen was added. If the nitrogen atomic concentration exceeded 25%, then the open-circuit voltage decreased.

### <Sixth Embodiment>

In a photovoltaic device according to a sixth embodiment of the present invention, the n-layer 43 of the second cell layer 92 shown in FIG. 21 is formed as a nitrogen-containing layer that comprises nitrogen atoms at an atomic concentration of not less than 1% and not more than 20% and has a crystallization ratio of not less than 0 but less than 3.

In the process for producing a photovoltaic device of the sixth embodiment, formation of the first cell layer 91 is substantially the same as that described for the fifth embodiment. Formation of the second cell layer 92 is substantially the same as that described for the second embodiment. In this embodiment also, an intermediate contact layer 5 may be provided between the first cell layer 91 and the second cell layer 92.

FIG. 23 is a graph illustrating the relationship between the nitrogen atomic concentration within the p-layer of the second cell layer and the open-circuit voltage of the solar cell module. In this figure, the horizontal axis represents the nitrogen atomic concentration, and the vertical axis represents the open-circuit voltage. The first cell layer was formed in the same manner as the first cell layer of the fifth embodiment. The deposition conditions for the second cell layer were the same as those described for the second embodiment.
Even in a tandem-type solar cell module, when the nitrogen atomic concentration within the n-layer was not less than 1% and not more than 20%, the open-circuit voltage was higher than that for a solar cell module in which no nitrogen was added. If the nitrogen atomic concentration exceeded 20%, then the open-circuit voltage decreased.

### <Seventh Embodiment

In a photovoltaic device according to a seventh embodiment of the present invention, a p/i interface layer composed of an intrinsic semiconductor layer comprising nitrogen atoms at an atomic concentration of not less than 1% and not more than 30% is formed between the p-layer 41 and the i-layer 42 of the second cell layer 92 in FIG. 21.

In the process for producing a photovoltaic device of the seventh embodiment, formation of the first cell layer 91 is substantially the same as that described for the fifth embodiment. Formation of the second cell layer 92 is substantially the same as that described for the third embodiment. In this embodiment also, an intermediate contact layer 5 may be provided between the first cell layer 91 and the second cell layer 92.

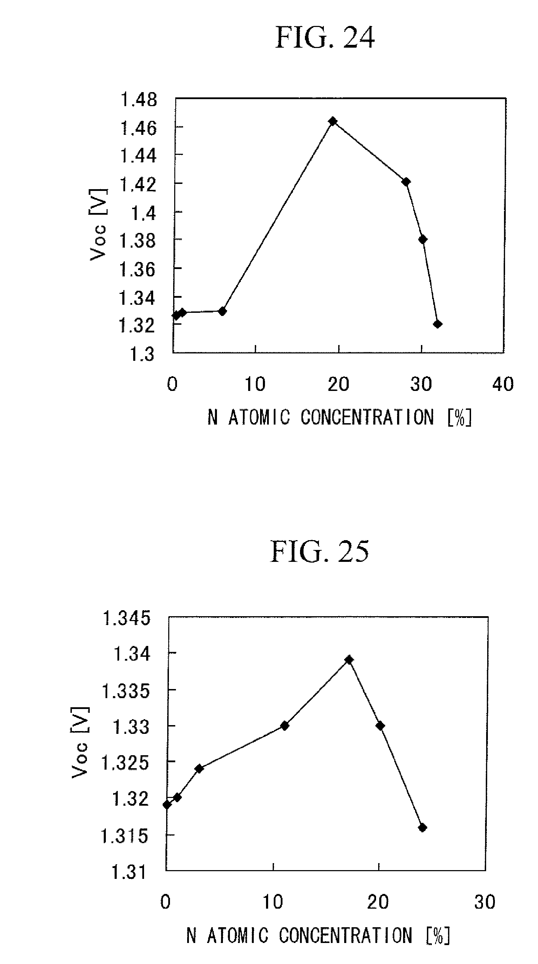

FIG. 24 is a graph illustrating the relationship between the nitrogen atomic concentration within the p/i interface layer and the open-circuit voltage of the solar cell module. In this figure, the horizontal axis represents the nitrogen atomic concentration, and the vertical axis represents the open-circuit voltage. The first cell layer was formed in the same manner as the first cell layer of the fifth embodiment. The deposition conditions for the second cell layer were the same as those described for the third embodiment. In a solar cell module in which the nitrogen atomic concentration within the p/i interface layer was not less than 1% and not more than 30%, the open-circuit voltage was higher than that for a solar cell module in which no nitrogen was added. If the nitrogen atomic concentration exceeded 30%, then the open-circuit voltage decreased.

### <Eighth Embodiment>

In a photovoltaic device according to an eighth embodiment of the present invention, an n/i interface layer composed of an intrinsic semiconductor layer comprising nitrogen atoms at an atomic concentration of not less than 1% and not more than 20% is formed between the i-layer 42 and the n-layer 43 of the second cell layer 92 in FIG. 21.

In the process for producing a photovoltaic device of the eighth embodiment, formation of the first cell layer 91 is substantially the same as that described for the fifth embodiment. Formation of the second cell layer 92 is substantially the same as that described for the fourth embodiment. In this embodiment also, an intermediate contact layer 5 may be provided between the first cell layer 91 and the second cell layer 92.

FIG. 25 is a graph illustrating the relationship between the nitrogen atomic concentration within the n/i interface layer and the open-circuit voltage of the solar cell module. In this figure, the horizontal axis represents the nitrogen atomic concentration, and the vertical axis represents the open-circuit voltage. The first cell layer was formed in the same manner as the first cell layer of the fifth embodiment. The deposition conditions for the second cell layer were the same as those described for the fourth embodiment. In a solar cell module in which the nitrogen atomic concentration within the p/i interface layer was not less than 1% and not more than 20%, the open-circuit voltage was higher than that for a solar cell module in which no nitrogen was added. If the nitrogen atomic concentration exceeded 20%, then the open-circuit voltage decreased.

The present invention is not limited to the embodiments described above, and various combinations are possible within the scope of the present invention. For example, the above embodiments described pn/i structures in which a p-layer, an i-layer and an n-layer were deposited in sequence from the sunlight-incident side of the device, but the present invention may also be applied to photovoltaic devices having a nip structure, in which an n-layer, an i-layer and a p-layer are deposited in sequence.

## Claims

1. A photovoltaic device comprising a photovoltaic layer having a stacked p-layer, i-layer and n-layer, wherein the p-layer is a nitrogen-containing layer comprising nitrogen atoms at an atomic concentration of not less than 1% and not more than 25%, and a crystallization ratio of the p-layer is not less than 0 but less than 3.

2. A photovoltaic device comprising a photovoltaic layer having a stacked p-layer, i-layer and n-layer, wherein the n-layer is a nitrogen-containing layer comprising nitrogen atoms at an atomic concentration of not less than 1% and not more than 20%, and a crystallization ratio of the n-layer is not less than 0 but less than 3.

3. A photovoltaic device comprising a photovoltaic layer having a stacked p-layer, i-layer and n-layer, wherein an interface layer is formed at an interface between the p-layer and the i-layer, and the interface layer is a nitrogen-containing layer comprising nitrogen atoms at an atomic concentration of not less than 1% and not more than 30%.

4. A photovoltaic device comprising a photovoltaic layer having a stacked p-layer, i-layer and n-layer, wherein an interface layer is formed at an interface between the n-layer and the i-layer, and the interface layer is a nitrogen-containing layer comprising nitrogen atoms at an atomic concentration of not less than 1% and not more than 20%.

5. The photovoltaic device according to claim 3 or claim 4, wherein the interface layer is an intrinsic semiconductor that comprises nitrogen.

6. The photovoltaic device according to any one of claim 3 through claim 5, wherein a thickness of the interface layer is not less than 2 nm and not more than 10 nm.

7. The photovoltaic device according to any one of claim 1 through claim 6, wherein the i-layer is a crystalline silicon layer.

8. A process for producing a photovoltaic device, comprising forming a photovoltaic layer by stacking a p-layer, an i-layer and an n-layer on top of a substrate, wherein
a nitrogen-containing layer comprising nitrogen atoms at an atomic concentration of not less than 1% and not more than 25% and having a crystallization ratio of not less than 0 but less than 3 is formed as the p-layer.

9. A process for producing a photovoltaic device, comprising forming a photovoltaic layer by stacking a p-layer, an i-layer and an n-layer on top of a substrate, wherein
a nitrogen-containing layer comprising nitrogen atoms at an atomic concentration of not less than 1% and not more than 20% and having a crystallization ratio of not less than 0 but less than 3 is formed as the n-layer.

10. A process for producing a photovoltaic device, comprising forming a photovoltaic layer by stacking a p-layer, an i-layer and an n-layer on top of a substrate, wherein
an interface layer is formed at an interface between the p-layer and the i-layer, and a nitrogen-containing layer comprising nitrogen atoms at an atomic concentration of not less than 1% and not more than 30% is formed as the interface layer.

11. A process for producing a photovoltaic device, comprising forming a photovoltaic layer by stacking a p-layer, an i-layer and an n-layer on top of a substrate, wherein
an interface layer is formed at an interface between the n-layer and the i-layer, and a nitrogen-containing layer comprising nitrogen atoms at an atomic concentration of not less than 1% and not more than 20% is formed as the interface layer.

12. The process for producing a photovoltaic device according to claim 10 or claim 11, wherein the interface layer is an intrinsic semiconductor that comprises nitrogen.

13. The process for producing a photovoltaic device according to any one of claim 10 through claim 12, wherein the interface layer is formed with a thickness of not less than 2 nm and not more than 10 nm.

14. The process for producing a photovoltaic device according to any one of claim 8 through claim 13, wherein the nitrogen-containing layer is formed by a radio-frequency plasma enhanced CVD method, at a radio frequency of not less than 30 MHz and not more than 100 MHz.
